(19) Europäisches Patentamt
European Patent Office
Office européen des brevets

(11) EP 4 763 853 A1

(12) **EUROPEAN PATENT APPLICATION**

(43) Date of publication:
**24.06.2026 Bulletin 2026/26**

(21) Application number: **24221294.2**

(22) Date of filing: **18.12.2024**

(51) International Patent Classification (IPC):
***C07F 15/02*** *(2006.01)* ***C09K 11/06*** *(2006.01)*
***H10K 85/60*** *(2023.01)*

(52) Cooperative Patent Classification (CPC):
**C07F 15/02; C09K 11/06; H10K 85/622**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Université catholique de Louvain**
**1348 Louvain-la-Neuve (BE)**

(72) Inventors:
- **TROIAN-GAUTIER, Ludovic**
  **1348 Louvain-la-Neuve (BE)**
- **GLASER, Felix**
  **1348 Louvain-la-Neuve (BE)**
- **DE KREIJGER, Simon**
  **1348 Louvain-la-Neuve (BE)**

(74) Representative: **Icosa**
**83 avenue Denfert-Rochereau**
**75014 Paris (FR)**

(54) **IRON-BASED PHOTOSENSITIZERS**

(57) The present invention relates to novel iron-based photosensitizers, especially compounds of formulae (I), wherein $R_1$, $R_2$, $R_3$, $R_4$, $R_5$, $R_6$, L, EnA and X are as defined in the claims, and uses thereof.

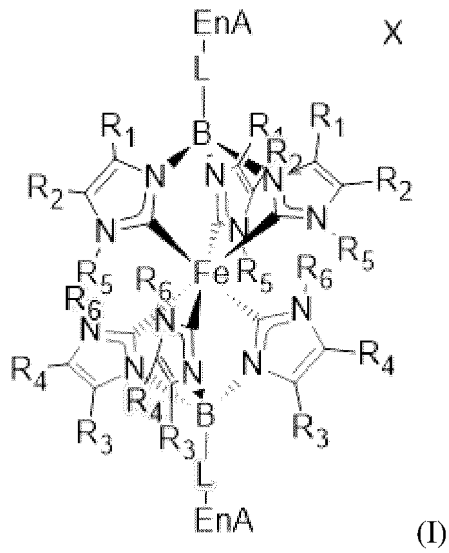

(I)

EP 4 763 853 A1

## Description

### FIELD OF INVENTION

The present invention relates to novel iron-based photosensitizers, especially compounds of formula (I) as detailed hereafter, and uses thereof.

### BACKGROUND OF INVENTION

Photo(redox) catalysis established itself as a credible alternative for catalysis to use light instead of heat as energy source. However, most of the technology that use photosensitizers rely on rare transition metal complexes such as (Ru(II), Ir(III) and Os(II)) or organic photosensitizers that usually suffer from low stability upon irradiation.

Iron, which is highly abundant and cheap, represents an interesting alternative but current iron-based photosensitizers have extremely short excited-state lifetime, typically in the picosecond timescale and they present poor cage escape yields. Although some examples with excited-state lifetime in the nanosecond (2-4 nanoseconds) timescale have been reported, this is still too short to be used as optimal photosensitizer. Indeed, to reach applications that operate via the formation of singlet oxygen, an excited-state lifetime of at least 50 nanoseconds is required.

Therefore, there is still a real need to develop new iron-based compounds, which have better properties as photosensitizers and/or photocatalysts. The excited-state lifetimes of these compounds shall notably be long enough to generate, or even enhance, photo(redox) catalysis via singlet oxygen formation or via excited-state electron transfer.

In addition, these compounds shall also be easily synthetized.

Surprisingly, the inventors have evidenced that combining a specific energy acceptor moiety to an iron (III) complex allows to simultaneously and drastically increase both the excited-state lifetime and the cage escape yields, thus efficiently expanding the applicability of iron (III) photosensitizers in photochemical and photophysical fields.

These new compounds can notably be used as photosensitizers in photo(redox) catalysis, photochemotherapy and solar fuels formation (in solution or in dye-sensitized photoelectrosynthetic cells).

### SUMMARY

This invention thus relates to compounds of formula (I):

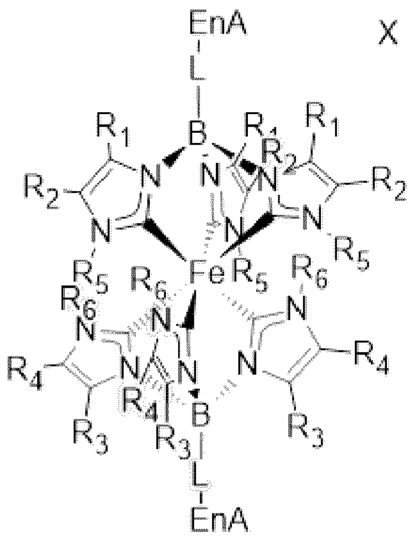

(I)

wherein $R_1$, $R_2$, $R_3$, $R_4$, $R_5$, $R_6$, L, EnA and X are as defined in the claims and hereafter.

Another aspect of the invention is directed to the use of a compound according to the invention as photosensitizer.

The invention further relates to the use of a compound according to the invention in solar cell, in solar panels, in lighting systems, in hydrogen production or in carbon dioxide conversion.

Still another aspect of the invention is directed to a composition comprising a compound according to the invention and a solvent as defined in the claims and hereafter.

The invention is also directed to a compound according to the invention or to a composition according to the invention for use in photodynamic or photochemotherapy therapy.

## DEFINITIONS

In the present invention, the following terms have the following meanings:

### Chemical definitions

When describing the compounds of the invention, the terms used are to be construed in accordance with the following definitions, unless indicated otherwise. Where chemical substituents are combinations of chemical groups, the point of attachment of the substituent to the molecule is by the last chemical group recited. For example, an arylalkyl substituent is bound to the rest of the molecule through the alkyl moiety and it may by represented as follows: "aryl-alkyl-".

**"Alkene"** or **"alkenyl"** refer to a linear or branched hydrocarbon chain comprising at least one double bond and typically from 2 to 12 carbon atoms, preferably 3 to 6 carbon atoms. Non-limiting examples of alkenyl groups include ethenyl, 2-propenyl, 2-butenyl, 3-butenyl, 2-pentenyl and its isomers, 2-hexenyl and its isomers and 2,4-pentadienyl.

**"Alkyl"** refers to a saturated linear or branched hydrocarbon chain, typically comprising from 1 to 12 carbon atoms, preferably from 1 to 6 carbon atoms, more preferably from 1 to 3 carbon atoms. In the present invention, alkyl groups may be monovalent or divalent (*i.e.*, "alkylene" groups are encompassed in "alkyl" definition). Non-limiting examples of alkyl groups include methyl, ethyl, *n*-propyl, *i*-propyl, *n*-butyl, *i*-butyl, *s*-butyl and *t*-butyl, pentyl and its isomers (*e.g.*, *n*-pentyl, *iso*-pentyl), and hexyl and its isomers (*e.g.*, *n*-hexyl, *iso*-hexyl). Preferred alkyl groups include methyl, ethyl, *n*-propyl, *i*-propyl, *n*-butyl, *s*-butyl and *t*-butyl.

**"Alkylaryl"** refers to an aryl group substituted by an alkyl group: alkyl-aryl-.

**"Alkylheteroaryl"** refers to a heteroaryl group substituted by an alkyl group: alkyl-heteroaryl-.

**"Alkyne"** or **"alkynyl"** refer to a linear or branched hydrocarbon chain comprising at least one triple bond and typically from 2 to 12 carbon atoms, preferably 2 to 6 carbon atoms. Examples of alkynyl groups include ethynyl, 2-propynyl, 2-butynyl, 3-butynyl, 2-pentynyl and its isomers, and 2-hexynyl and its isomers.

**"Aryl"** refers to a cyclic, polyunsaturated, aromatic hydrocarbyl group comprising at least one aromatic ring. Aryl groups may have a single ring (*i.e.,* phenyl) or multiple aromatic rings fused together (*e.g*., naphthyl) or linked covalently. Typically, aryl groups have from 5 to 12 carbon atoms, preferably from 6 to 10 carbon atoms. The aromatic ring may optionally include one or more additional rings (either cycloalkyl, heterocycloalkyl or heteroaryl) fused thereto. Aryl is also intended to include the partially hydrogenated derivatives of the carbocyclic systems enumerated herein, as long as at least one ring is aromatic. Non-limiting examples of aryl groups include phenyl, biphenyl, biphenylenyl, 5- or 6-tetralinyl, naphthalen-1- or -2-yl, 4-, 5-, 6 or 7-indenyl, 1- 2-, 3-, 4- or 5-acenaphthylenyl, 3-, 4- or 5-acenaphthenyl, 1- or 2-pentalenyl, 4- or 5-indanyl, 5-, 6-, 7- or 8-tetrahydronaphthyl, 1,2,3,4-tetrahydronaphthyl, 1,4-dihydronaphthyl, 1-, 2-, 3-, 4- or 5-pyrenyl, pyrene or terphenyl. A preferred aryl group is phenyl.

**"Arylalkyl"** refers to an alkyl group substituted by an aryl group: aryl-alkyl-.

**"($C_x$-$C_y$)"** preceding a group means that the group comprises from x to y carbon atoms, in accordance to common terminology in the chemistry field.

**"Cycloalkyl"** refers to a cyclic monovalent alkyl, typically comprising from 3 to 11 carbon atoms, preferably from 4 to 9 carbon atoms, more preferably from 5 to 7 carbon atoms. This definition encompasses polycyclic cycloalkyls (*e.g.*, bicycles) and bridged cycloalkyl structures, including cycles bound together through one atom ("spiro") or through two atoms.

**"Halide", "halo"** or **"halogen"** refers to a fluorine, chlorine, bromine or iodine atom; preferably a chlorine or bromine atom.

**"Heteroalkyl"** refers to an alkyl group as defined hereinabove wherein one or more carbon atoms are replaced by a heteroatom selected from oxygen, nitrogen and sulfur. In heteroalkyl groups, the heteroatoms are bound along the alkyl chain only to carbon atoms, *i.e.,* each heteroatom is separated from any other heteroatom by at least one carbon atom. The nitrogen and sulfur heteroatoms may optionally be oxidized and the nitrogen heteroatoms may optionally be quaternized. A heteroalkyl is bond to another group or molecule only through a carbon atom, *i.e.,* the bounding atom is not selected among the heteroatoms included in the heteroalkyl group. Non-limiting examples of heteroalkyl include alkoxy, ethers and polyethers, secondary amines, tertiary amines and thioethers.

**"Heteroaryl"** refers to aromatic rings or aromatic ring systems comprising from 5 to 12 carbon atoms, preferably from 6 to 10 carbon atoms, having one or two rings which are fused together or linked covalently, wherein at least one ring is aromatic, and wherein one or more carbon atoms in one or more of these rings is replaced by oxygen, nitrogen, phosphor, silicium and/or sulfur atoms, preferably oxygen, nitrogen and/or sulfur atoms. "Heteroaryl" may also be viewed as an "aryl" group as defined herein, wherein at least one carbon atom in the aryl group is replaced with a heteroatom and wherein the resulting molecule is chemically stable. The nitrogen and sulfur heteroatoms may optionally be oxidized and the nitrogen heteroatoms may optionally be quaternized. Non-limiting examples of heteroaryl groups include furanyl, thiophenyl, pyrazolyl, imidazolyl, oxazolyl, isoxazolyl, thiazolyl, isothiazolyl, triazolyl, oxadiazolyl, thiadiazolyl, tetrazolyl, oxatriazolyl, thiatriazolyl, pyridinyl, pyrimidyl, pyrazinyl, pyridazinyl, oxazinyl, dioxinyl, thiazinyl, triazinyl, imidazo[2,1-b][1,3] thiazolyl,

thieno[3,2-b]furanyl, thieno[3,2-b]thiophenyl, thieno[2,3-d][1,3]thiazolyl, thieno[2,3-d]imidazolyl, tetrazolo[1,5-a]pyridinyl, indolyl, indolizinyl, isoindolyl, benzofuranyl, isobenzofuranyl, benzothiophenyl, isobenzothiophenyl, indazolyl, benzimidazolyl, 1,3-benzoxazolyl, 1,2-benzisoxazolyl, 2,1-benzisoxazolyl, 1,3-benzothiazolyl, 1,2-benzoisothiazolyl, 2,1-benzoisothiazolyl, benzotriazolyl, 1,2,3-benzoxadiazolyl, 2,1,3-benzoxadiazolyl, 1,2,3-benzothiadiazolyl, 2,1,3-benzothiadiazolyl, thienopyridinyl, purinyl, imidazo[1,2-a]pyridinyl, 6-oxo-pyridazin-1(6H)-yl, 2-oxopyridin-l(2H)-yl, 6-oxo-pyridazin-l(6H)-yl, 2-oxopyridin-l(2H)-yl, 1,3-benzodioxolyl, quinolinyl, isoquinolinyl, cinnolinyl, quinazolinyl and quinoxalinyl.

**"Heteroarylalkyl"** refers to an alkyl group substituted by a heteroaryl group: heteroaryl-alkyl-.

**"Heterocycloalkyl"** refers to a cyclic monovalent heteroalkyl, typically comprising from 2 to 7 carbon atoms, preferably from 3 to 6 carbon atoms, more preferably from 4 to 5 carbon atoms. This definition encompasses polycyclic heterocycloalkyls (*e.g.*, bicycles) and bridged heterocycloalkyl structures, including cycles bound together through one atom ("spiro") or through two atoms. In one embodiment, the heterocycloalkyl is bound to another group or molecule through a carbon atom, *i.e.,* the binding atom is not selected among the heteroatoms included therein. In one embodiment, the heterocycloalkyl is bound to another group or molecule through one of the heteroatoms included therein. When substituted by one or more other group(s), an heterocycloalkyl may be substituted either through a carbon atom or through a heteroatom (*e.g.*, nitrogen), unless otherwise specified. Non-limiting examples of heterocycloalkyl include aziridine, pyrrolidine, piperidine, piperazine (also known as "hexahydropyrazine"), morpholine, thiomorpholine, azepane, azocane, octahydro-*1H*-isoindole, decahydroisoquinoline, tetrahydrofuran, tetrahydropyran, tetrahydroisoquinoline (*e.g.,* 1,2,3,4-tetrahydroisoquiline), hexahydropyridazine, hexahydropyrimidine, decahydroquinoline, octahydropyrrolo[3,4-c]pyrrole, isoindoline, 1,2,3,4-tetrahydroquinoline and oxetane.

The alkyl, aryl or any other group defined hereabove can be **optionally substituted,** meaning that said group can be substituted, or not, by one or more substituents chosen independently of one another, among linear or branched alkyl group, linear or branched heteroalkyl group, cycloalkyl group, heterocycloalkyl group, aryl group, heteroaryl group, hydroxy group (-OH), amino group ($-NH_2$), a halogen atom, a cyano group, -COOH, $-PO_3H_2$, $-PO_3RR'$, -NRR', -COOR, -CONRR'; where R and R' being each independently selected from H, alkyl or aryl.

The alkyl, aryl or any other group defined hereabove can be optionally interrupted meaning that one or more carbon atoms in the group may be replaced by oxygen, nitrogen, phosphor, silicium and/or sulfur atoms, preferably by oxygen, nitrogen and/or sulfur atoms.

**"Homoleptic compound of complex"** refers to a metal compound or complex wherein all its ligands are identical. In comparison, a metal compound or complex having different ligands is a **"heteroleptic compound of complex".**

**"Linker"** refers to a moiety that covalently binds two molecules to one another and comprises a series of multivalent atoms selected from C, N, O, S and P bound together by stable covalent bonds. The moiety typically incorporates 1 to 30 atoms, for example 1, 2, 3, 4, 5, 6, 7, 8, 9, 10, 15, 20, 25 or 30. A linker may be linear or non-linear, some linkers have pendant side chains or pendant functional groups or both. In one embodiment, a linker is composed of any combination of single, double, triple or aromatic carbon-carbon bonds, carbon-nitrogen bonds, nitrogen-nitrogen bonds, carbon-oxygen bonds and carbon-sulfur bonds. In one embodiment, a linker consists of a combination of moieties selected from alkyl, -C(O)NH-, -C(O)O-, -NH-, -S-, -O-, - C(O)-, -S(O)-, $-S(O)_2$ and 5- or 6-membered monocyclic aryls or heteroaryls. In one embodiment, the linker comprises at least one "coupling product" as defined herein, typically one or two coupling products. In this context, "comprise" means that the linker can be interrupted by at least one coupling product (*i.e.,* the coupling product is incorporated into the atomic chain of the linker) and/or that the linker can end with at least one coupling product (*i.e.,* the coupling product terminates the linker). In this embodiment, the coupling product is considered part of the linker, which means in particular that the atoms of the coupling product are counted among the total number of atoms of the linker.

**"Anionic counterion"** refers to an anion or a mixture of anions derived from salt(s) of organic or mineral acid(s) counterbalancing the cationic charge of the compound of the present invention; more particularly the anionic counterion is chosen from i) halides such as chloride, bromide or iodide; ii) nitrates such as $NO_3^-$; iii) sulfonates including $C_1$-$C_6$ alkylsulfonates: Alk-$S(O)_2O^-$ such as methylsulfonate or mesylate and ethylsulfonate; iv) arylsulfonates: Ar-$S(O)_2O^-$ such as benzenesulfonate and toluenesulfonate or tosylate ($TsO^-$); v) citrate; vi) succinate; vii) tartrate; viii) lactate; ix) alkyl sulfates: Alk-O-$S(O)O^-$ such as methyl sulfate and ethyl sulfate; x) aryl sulfates: Ar-O-$S(O)O^-$ such as benzene sulfate and toluene sulfate; xi) alkoxy sulfates: Alk-O-$S(O)_2O^-$ such as methoxy sulfate and ethoxy sulfate; xii) aryloxy sulfates: Ar-O-$S(O)_2O^-$, xiii) phosphates; xiv) acetate; xv) triflate ($TfO^-$); xvi) borates such as $BF_4^-$, $BPh_4^-$ or $[BAr^F{}_4]^-$, xvii) disulfate; and xviii) perchlorate ($ClO_4^-$).The anionic counterion, derived from an organic or mineral acid salt, ensures the electroneutrality of the molecule, so it is understood that when the anion comprises several anionic charges then the same anion can serve for the electroneutrality of several cationic groups in the same molecule or can serve for the electroneutrality of several molecules.

**"Cationic counterion"** refers to a cation or a mixture of cations derived from salt(s) of organic or mineral base(s) counterbalancing the anionic charge of the compound of the present invention; more particularly the cationic counterion is

chosen from alkali metal (such as sodium, potassium) cations, the ammonium ion ($NH_4^+$), amines or aminoalcohols. The cationic counterion, derived from an organic or mineral basic salt, ensures the electroneutrality of the molecule, so it is understood that when the cation comprises several cationic charges then the same cation can serve for the electroneutrality of several anionic groups in the same molecule or can serve for the electroneutrality of several molecules.

**General definitions**

**"About"** is used herein to mean approximately, roughly, around, or in the region of. The term "about" preceding a figure means plus or less 10 % of the value of the figure. When the term "about" is used in conjunction with a numerical range, it modifies that range by extending the boundaries above and below the numerical values set forth by 10%.
**"at least"** is equivalent to the expression **"one or more".**
**"Comprising"** or **"comprise"** is to be construed in an open, inclusive sense, but not limited to.
**"From X to Y"** refers to the range of values between X and Y, the limits X and Y being included in said range.

**DETAILED DESCRIPTION**

**Iron-based photosensitizers of formulae (I)-(IV)**

This invention relates to a compound, i.e. an iron-based photosensitizers, of formula (I):

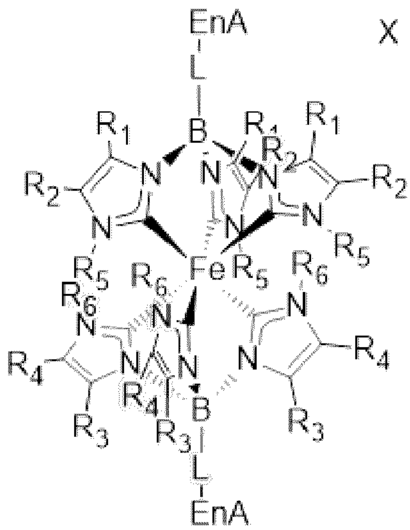

(I)

wherein,

- $R_1$, $R_2$, $R_3$ and $R_4$, identical or different, represent, independently from one another, H, a halogen, a linear or branched, saturated or unsaturated, $C_1$-$C_{12}$ alkyl, an aryl, an heteroaryl or $R_1/R_2$ or $R_3/R_4$ form together with the carbon atoms to which they are attached, an aromatic $C_5$-$C_6$ ring; wherein said alkyl, aryl, heteroaryl or aromatic ring being optionally substituted;
- $R_5$ and $R_6$, identical or different, represent, independently from one another, H, a linear or branched, saturated or unsaturated, $C_1$-$C_{12}$ alkyl, a $C_3$-$C_7$ cycloalkyl, or an aryl; wherein said alkyl, cycloalkyl or aryl being optionally substituted;
- each L represents independently a single bond or a linker, selected from alkyl, heteroalkyl, cycloalkyl, heterocycloalkyl, alkenyl, alkynyl, aryl, alkylaryl, arylalkyl, heteroaryl, heteroarylalkyl and alkylheteroaryl; wherein said alkyl, heteroalkyl, cycloalkyl, heterocycloalkyl alkenyl, alkynyl, aryl, alkylaryl, arylalkyl, heteroaryl, heteroarylalkyl or alkylheteroaryl being optionally substituted;
- each EnA represents independently an energy acceptor, preferably selected from polycyclic aromatic hydrocarbons comprising at least 3 aromatic rings fused together, at least one of the aromatic rings being optionally interrupted and/or optionally substituted; and
- X represents an inorganic or organic counterion, ensuring the electrical neutrality of the compound; with the proviso that when L represents a single bond or

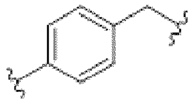

-;

EnA does not represent a pyrene, i.e.

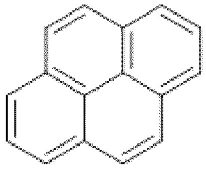

.

**"Energy acceptor** ", i.e. **EnA,** refers to a group which is able to accept an electron. According to the present invention, the energy level of the energy acceptor EnA is lower than or equal to the energy level of the iron center of the compound of the invention. Preferably, the energy level of the energy acceptor EnA is lower than the energy level of the iron center of the compound of the invention. More preferably, the difference between the energy level of the energy acceptor EnA and the energy level of the iron center of the compound of the invention ranges from 100 to 600 meV. The energy level can be measured by any known methods in the art. It can notably be measured by phosphorescence measurements at 77K, and then estimated from the onset of the phosphorescence. It can also be measured by the Rehm-Weller approach.

Advantageously, each EnA represents independently an energy acceptor selected from polycyclic aromatic hydrocarbons comprising from 3 to 70, preferably from 3 to 20, more preferably from 3 to 10 aromatic rings fused together, at least one of the aromatic rings being optionally interrupted and/or optionally substituted; preferably at least one of the aromatic rings being optionally interrupted by one or more heteroatoms selected among N, S or O and/or optionally substituted by one or more groups selected among =S, =O, a phenyl or a linear or branched, saturated or unsaturated, $C_1$-$C_6$ alkyl chain.

According to a preferred embodiment, EnA does not represent a pyrene.

According to another preferred embodiment, when EnA represents a pyrene at least one of the aromatic rings is interrupted and/or substituted; preferably at least one of the aromatic rings is interrupted by one or more heteroatoms selected among N, S or O and/or substituted by one or more groups selected among =S, =O, a phenyl or a linear or branched, saturated or unsaturated, $C_1$-$C_6$ alkyl chain.

According to a preferred embodiment, each L represents independently a single bond or a linker selected from, substituted or unsubstituted, $C_1$-$C_6$ alkyl, $C_1$-$C_6$ heteroalkyl, $C_3$-$C_6$ cycloalkyl, $C_3$-$C_6$ heterocycloalkyl, aryl, ($C_2$-$C_6$) alkylaryl, aryl($C_1$-$C_6$)alkyl, heteroaryl, heteroaryl($C_1$-$C_6$)alkyl and alkylheteroaryl. Preferably, each L represents independently a linker selected from, substituted or unsubstituted, aryl, ($C_2$-$C_6$)alkylaryl, aryl($C_1$-$C_6$)alkyl, heteroaryl, heteroaryl($C_1$-$C_6$)alkyl and alkylheteroaryl. More preferably, each L represents a phenyl.

X represents an inorganic or organic counterion, ensuring the electrical neutrality of the compound. In other words, depending on the electrical charge of the compound, X may represent an inorganic or organic anionic counterion or an inorganic or organic cationic counterion. X may also be absent when the compound is neutral in itself.

Advantageously, the compounds of the present invention are chosen from the compounds of formula (II):

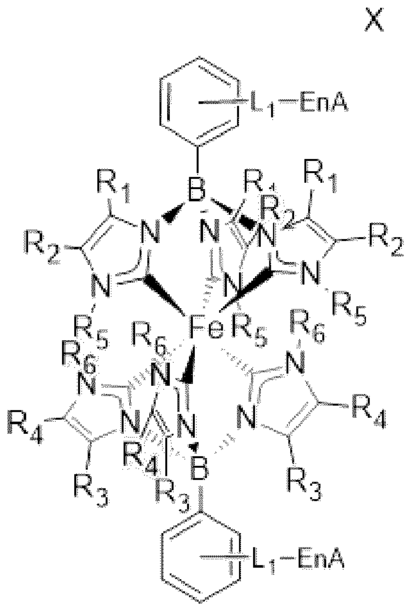

(II)

wherein, $R_1$, $R_2$, $R_3$, $R_4$, $R_5$, $R_6$, EnA and X are as defined hereabove; and

- each $L_1$ represents independently a single bond or a linker selected from alkyl, heteroalkyl, cycloalkyl, heterocycloalkyl, alkenyl, alkynyl, aryl, alkylaryl, arylalkyl, heteroaryl, heteroarylalkyl and alkylheteroaryl; wherein said alkyl, heteroalkyl, cycloalkyl, heterocycloalkyl alkenyl, alkynyl, aryl, alkylaryl, arylalkyl, heteroaryl, heteroarylalkyl or alkylheteroaryl being optionally substituted;

with the proviso that when $L_1$ represents a single bond in para position; EnA does not represent a pyrene, i.e.

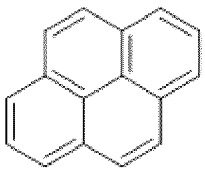

.

Advantageously, the compounds of the present invention are chosen from the compounds of formula (III):

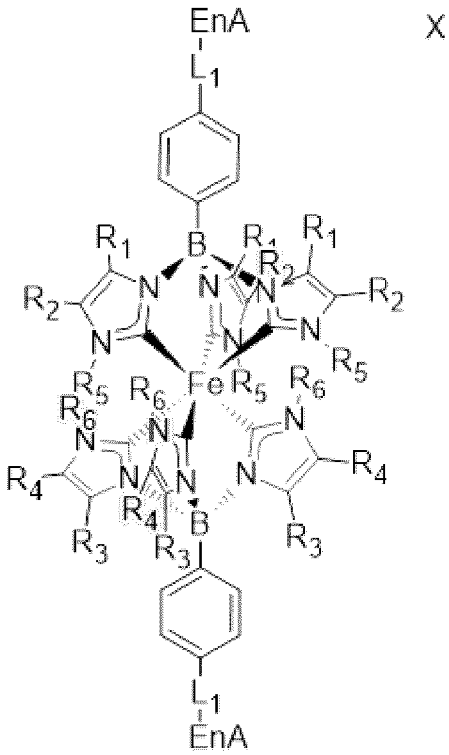

(III)

wherein, $R_1$, $R_2$, $R_3$, $R_4$, $R_5$, $R_6$, $L_1$, EnA and X are as defined hereabove; with the proviso that when $L_1$ represents a single bond; EnA does not represent a pyrene, i.e.

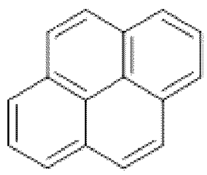

.

Advantageously, the compounds of the present invention are chosen from the compounds of formula (IV):

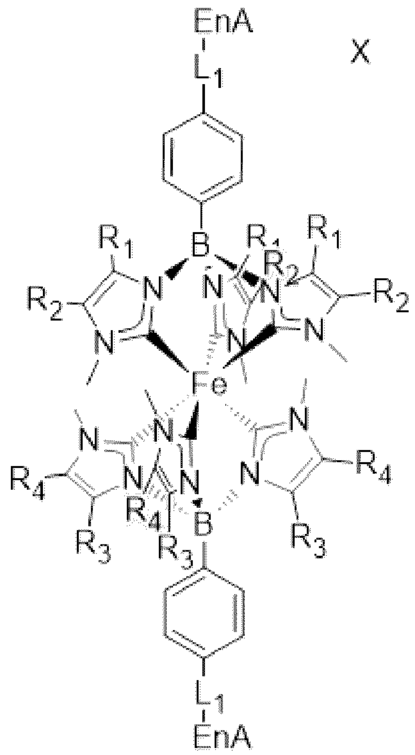

(IV)

wherein, $R_1$, $R_2$, $R_3$ and $R_4$, $L_1$, EnA and X are as defined hereabove; with the proviso that when $L_1$ represents a single bond; EnA does not represent a pyrene, i.e.

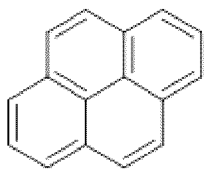

.

Preferably, the compounds of the present invention are chosen from the compounds of formula (IV), wherein

- $R_1$, $R_2$, $R_3$ and $R_4$, identical or different, represent, independently from one another, H, a halogen, a linear or branched, saturated or unsaturated, $C_1$-$C_{12}$ alkyl, an aryl, an heteroaryl or $R_1/R_2$ or $R_3/R_4$ form together with the carbon atoms to which they are attached, an aromatic $C_5$-$C_6$ ring; wherein said alkyl, aryl, heteroaryl or aromatic ring being optionally substituted;
- each $L_1$ represents independently a single bond or a linker selected from alkyl, heteroalkyl, cycloalkyl, heterocycloalkyl, alkenyl, alkynyl, aryl, alkylaryl, arylalkyl, heteroaryl, heteroarylalkyl and alkylheteroaryl; wherein said alkyl, heteroalkyl, alkenyl, alkynyl, aryl, alkylaryl, arylalkyl, heteroaryl, heteroarylalkyl or alkylheteroaryl being optionally substituted;
- each EnA represents independently an energy acceptor, preferably selected from polycyclic aromatic hydrocarbons comprising at least 3 aromatic rings fused together, at least one of the aromatic rings being optionally interrupted by one or more heteroatoms selected among N, S or O and/or optionally substituted by one or more groups selected among =S, =O, a phenyl or a linear or branched, saturated or unsaturated, $C_1$-$C_6$ alkyl chain; and
- $X^-$ represents an inorganic or organic counterion, ensuring the electrical neutrality of the compound;

with the proviso that when L represents a $-CH_2-$; EnA does not represent a pyrene, i.e.

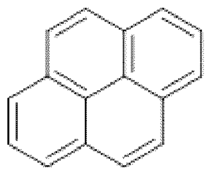

.

According to a first embodiment, $R_1$ and $R_2$ are identical, while $R_3$ and $R_4$ are different from one another and from $R_1$ and $R_2$; $R_1$, $R_2$, $R_3$ and $R_4$, represent, H, a halogen, a linear or branched, saturated or unsaturated, $C_1$-$C_{12}$ alkyl, an aryl, an heteroaryl, or $R_1/R_2$ or $R_3/R_4$ form together with the carbon atoms to which they are attached, an aromatic $C_5$-$C_6$ ring; wherein said alkyl, aryl, heteroaryl, or aromatic ring being optionally substituted. According to this embodiment, $R_1$, $R_2$, $R_3$ and $R_4$, preferably represent, H, a linear or branched, saturated or unsaturated, $C_1$-$C_6$ alkyl or $R_1/R_2$ or $R_3/R_4$ form together with the carbon atoms to which they are attached, an aromatic $C_5$-$C_6$ ring; wherein said alkyl or aromatic ring being optionally substituted, preferably not substituted.

According to another embodiment, $R_3$ and $R_4$ are identical, while $R_1$ and $R_2$ are different from one another and from $R_3$ and $R_4$; $R_1$, $R_2$, $R_3$ and $R_4$, represent, H, a halogen, a linear or branched, saturated or unsaturated, $C_1$-$C_{12}$ alkyl, an aryl, an heteroaryl, or $R_1/R_2$ or $R_3/R_4$ form together with the carbon atoms to which they are attached, an aromatic $C_5$-$C_6$ ring; wherein said alkyl, aryl, heteroaryl or aromatic ring being optionally substituted. According to this embodiment, $R_1$, $R_2$, $R_3$ and $R_4$, preferably represent, H, a linear or branched, saturated or unsaturated, $C_1$-$C_6$ alkyl or $R_1/R_2$ or $R_3/R_4$ form together with the carbon atoms to which they are attached, an aromatic $C_5$-$C_6$ ring; wherein said alkyl or aromatic ring being optionally substituted, preferably not substituted.

According to another embodiment, $R_1$, $R_2$, $R_3$ and $R_4$ are all different from one another and represent H, a halogen, a linear or branched, saturated or unsaturated, $C_1$-$C_6$ alkyl, an aryl or an heteroaryl; wherein said alkyl, aryl or heteroaryl, being optionally substituted, preferably not substituted. According to this embodiment, $R_1$, $R_2$, $R_3$ and $R_4$, preferably represent H or a linear or branched, saturated or unsaturated, $C_1$-$C_6$ alkyl, said alkyl being optionally substituted, preferably not substituted.

According to still another embodiment, $R_1$, $R_2$, $R_3$ and $R_4$ are identical and represent H, a halogen, a linear or branched, saturated or unsaturated, $C_1$-$C_6$ alkyl, an aryl or an heteroaryl; wherein said alkyl, aryl or heteroaryl, being optionally substituted, preferably not substituted. According to this embodiment, $R_1$, $R_2$, $R_3$ and $R_4$, preferably represent H or a linear or branched, saturated or unsaturated $C_1$-$C_6$ alkyl, preferably H.

According to another embodiment, $R_1/R_2$ or $R_3/R_4$ form together with the carbon atoms to which they are attached, an aromatic $C_5$-$C_6$ ring, optionally substituted.

According to a preferred embodiment, each $L_1$ represents independently a single bond or a linker selected from, substituted or unsubstituted, $C_2$-$C_6$ alkyl, $C_1$-$C_6$ heteroalkyl, $C_3$-$C_6$ cycloalkyl, $C_3$-$C_6$ heterocycloalkyl, aryl, ($C_1$-$C_6$) alkylaryl, aryl($C_1$-$C_6$)alkyl, heteroaryl, heteroaryl($C_1$-$C_6$)alkyl and alkylheteroaryl. Preferably, each L represents independently a single bond or a linker selected from, substituted or unsubstituted, aryl, ($C_1$-$C_6$)alkylaryl, aryl($C_1$-$C_6$)alkyl, heteroaryl, heteroaryl($C_1$-$C_6$)alkyl and alkylheteroaryl.

Advantageously, $L_1$ are identical and represent a single bond or a linker selected from, substituted or unsubstituted, $C_2$-$C_6$ alkyl, $C_1$-$C_6$ heteroalkyl, $C_3$-$C_6$ cycloalkyl, $C_3$-$C_6$ heterocycloalkyl, aryl, ($C_1$-$C_6$)alkylaryl, aryl($C_1$-$C_6$)alkyl, heteroaryl, heteroaryl($C_1$-$C_6$)alkyl and alkylheteroaryl. Preferably, each L represents independently a single bond or a linker selected from, substituted or unsubstituted, aryl, ($C_1$-$C_6$)alkylaryl, aryl($C_1$-$C_6$)alkyl, heteroaryl, heteroaryl($C_1$-$C_6$) alkyl and alkylheteroaryl.

Advantageously, $L_1$ are identical and represent a single bond.

Advantageously, each EnA represents independently an energy acceptor selected from polycyclic aromatic hydrocarbons comprising from 3 to 6, preferably from 3 to 5, aromatic rings fused together, at least one of the aromatic rings being optionally interrupted by one or more heteroatoms selected among N, S or O and/or optionally substituted by one or more groups selected among =S, =O, a phenyl or a linear or branched, saturated or unsaturated, $C_1$-$C_6$ alkyl chain. Preferably with the proviso that when EnA represents a pyrene, at least one of the aromatic rings is interrupted and/or substituted; preferably at least one of the aromatic rings is interrupted by one or more heteroatoms selected among N, S or O and/or substituted by one or more groups selected among =S, =O, a phenyl or a linear or branched, saturated or unsaturated, $C_1$-$C_6$ alkyl chain.

Advantageously, EnA are identical.

Advantageously, EnA are identical and represent an energy acceptor preferably selected from polycyclic aromatic hydrocarbons comprising from 3 to 6, preferably from 3 to 5, aromatic rings fused together, at least one of the aromatic rings being optionally interrupted by one or more heteroatoms selected among N, S or O and/or optionally substituted by one or more groups selected among =S, =O, a phenyl or a linear or branched, saturated or unsaturated, $C_1$-$C_6$ alkyl chain. Preferably with the proviso that when EnA represents, a pyrene at least one of the aromatic rings is interrupted and/or substituted; preferably at least one of the aromatic rings is interrupted by one or more heteroatoms

selected among N, S or O and/or substituted by one or more groups selected among =S, =O, a phenyl or a linear or branched, saturated or unsaturated, $C_1$-$C_6$ alkyl chain.

More preferably, EnA are identical and represent an energy acceptor selected from polycyclic aromatic hydrocarbons comprising from 3 to 6, preferably from 3 to 5, aromatic rings fused together, at least one of the aromatic rings being substituted by one or more groups selected among a phenyl or a linear or branched, saturated or unsaturated, $C_1$-$C_6$ alkyl chain, preferably a phenyl.

Advantageously, EnA are identical and represent an energy acceptor preferably selected from pyrene, anthracene, and perylene groups; said groups being optionally interrupted and/or optionally substituted; preferably said groups being optionally interrupted by one or more heteroatoms selected among N, S or O and/or optionally substituted by one or more groups selected among =S, =O, a phenyl or a linear or branched, saturated or unsaturated, $C_1$-$C_6$ alkyl chain. Preferably, EnA are identical and represent an energy acceptor preferably selected from anthracene and perylene groups; said groups being optionally interrupted and/or optionally substituted; preferably said groups being optionally interrupted by one or more heteroatoms selected among N, S or O and/or optionally substituted by one or more groups selected among =S, =O, a phenyl or a linear or branched, saturated or unsaturated, $C_1$-$C_6$ alkyl chain.

Advantageously, EnA is not a pyrene.

Advantageously, EnA is independently selected from:

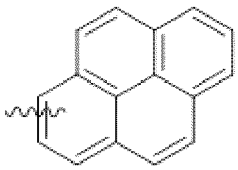 , 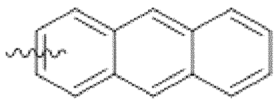 , 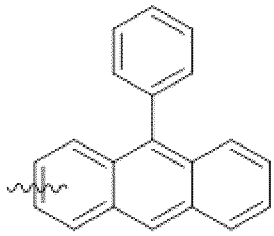 , 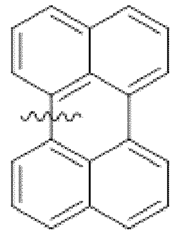 ,

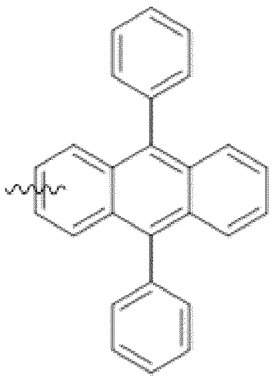 , 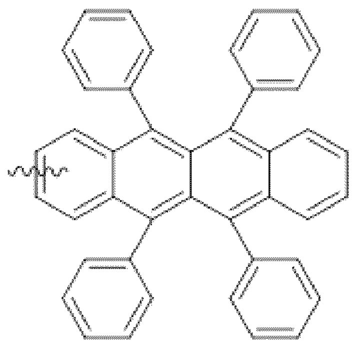 , 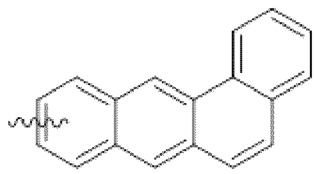 ,

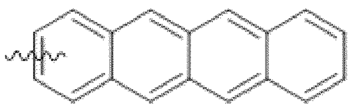 , 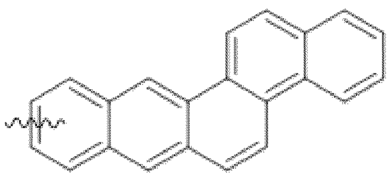 , 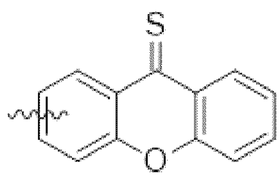 ,

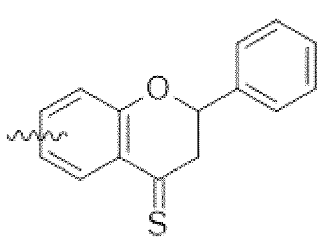 , 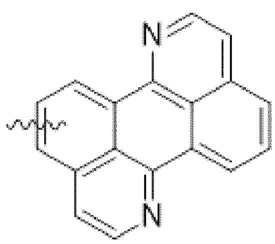 , and 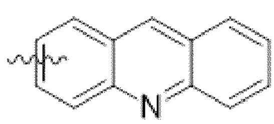 ;

wherein  represents the single bond between L or $L_1$ and EnA; said bond being attached to any carbon atoms or

heteroatom.

Preferably, EnA is independently selected from:

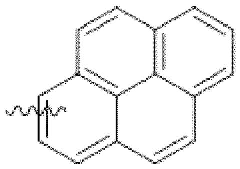, 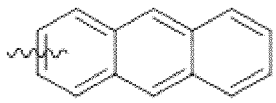, 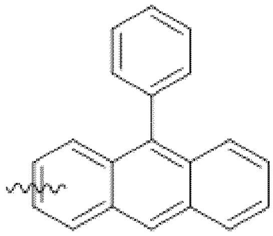, and 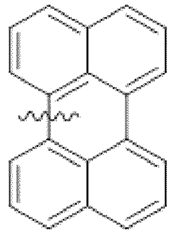;

wherein 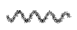 represents the single bond between L or $L_1$ and EnA; said bond being attached to any carbon atoms or heteroatom.

More preferably, EnA is independently selected from:

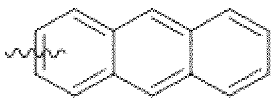, 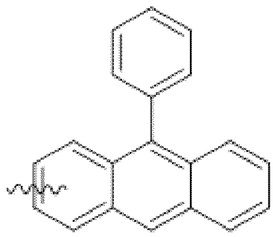, and 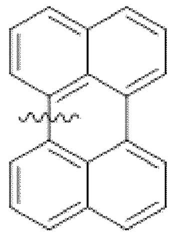;

wherein 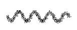 represents the single bond between L or $L_1$ and EnA; said bond being attached to any carbon atoms or heteroatom.

According to a preferred embodiment, the compounds of the present invention are chosen from the compounds of formula (IV), wherein:

- $R_1$, $R_2$, $R_3$ and $R_4$, identical or different, represent, independently from one another, H, a linear or branched, saturated or unsaturated, $C_1$-$C_{12}$ alkyl, preferably $C_1$-$C_6$ alky or $R_1$/$R_2$ or $R_3$/$R_4$ together with the carbon atoms to which they are attached, an aromatic $C_5$-$C_6$ ring; wherein said alkyl or aromatic ring being optionally substituted, preferably not substituted;
- each $L_1$ represents independently a single bond or a linker selected from, substituted or unsubstituted, $C_2$-$C_6$ alkyl, $C_1$-$C_6$ heteroalkyl, $C_3$-$C_6$ cycloalkyl, $C_3$-$C_6$ heterocycloalkyl, aryl, ($C_1$-$C_6$)alkylaryl, aryl($C_1$-$C_6$)alkyl, heteroaryl, heteroaryl($C_1$-$C_6$)alkyl and alkylheteroaryl;
- EnA represents independently an energy acceptor selected from polycyclic aromatic hydrocarbons comprising at least 3 aromatic rings fused together, at least one of the aromatic rings being optionally interrupted by one or more heteroatoms selected among N, S or O and/or optionally substituted by one or more groups selected among =S, =O, a phenyl or a linear or branched, saturated or unsaturated, $C_1$-$C_6$ alkyl chain; and
- $X^-$ represents an inorganic or organic counterion, preferably an inorganic or organic anionic counterion, ensuring the electrical neutrality of the compound.

According to this preferred embodiment, preferably, when EnA represents a pyrene, at least one of the aromatic rings is interrupted and/or substituted; preferably at least one of the aromatic rings is interrupted by one or more heteroatoms selected among N, S or O and/or substituted by one or more groups selected among =S, =O, a phenyl or a linear or branched, saturated or unsaturated, $C_1$-$C_6$ alkyl chain. More preferably, EnA is not a pyrene.

According to a preferred embodiment, the compound of the present invention is chosen from the compounds of formula (IV), wherein

- $R_1$, $R_2$, $R_3$ and $R_4$, identical or different, represent, independently from one another, H, a linear or branched, saturated or unsaturated, $C_1$-$C_{12}$ alkyl, preferably $C_1$-$C_6$ alky, or $R_1$/$R_2$ or $R_3$/$R_4$ form together with the carbon atoms to which they are attached, an aromatic $C_5$-$C_6$ ring; wherein said alkyl or aromatic ring being optionally substituted, preferably not substituted;
- Li represent a single bond;
- each EnA represents independently an energy acceptor, preferavly selected from polycyclic aromatic hydrocarbons

comprising at least 3, preferably from 3 to 6, more preferably from 3 to 5, aromatic rings fused together, at least one of the aromatic rings being optionally interrupted by one or more heteroatoms selected among N, S or O and/or optionally substituted by one or more groups selected among =S, =O, a phenyl or a linear or branched, saturated or unsaturated, $C_1$-$C_6$ alkyl chain; and
- $X^-$ represents an inorganic or organic counterion, preferably an inorganic or organic anionic counterion, ensuring the electrical neutrality of the compound.

According to this preferred embodiment, preferably, when EnA represents a pyrene, at least one of the aromatic rings is interrupted and/or substituted; preferably at least one of the aromatic rings is interrupted by one or more heteroatoms selected among N, S or O and/or substituted by one or more groups selected among =S, =O, a phenyl or a linear or branched, saturated or unsaturated, $C_1$-$C_6$ alkyl chain. More preferably, EnA is not a pyrene.

According to another preferred embodiment, the compound of the present invention is chosen from the compounds of formula (IV), wherein

- $R_1$, $R_2$, $R_3$ and $R_4$ are identical and represent H, a linear or branched, saturated or unsaturated, $C_1$-$C_{12}$ alkyl, preferably $C_1$-$C_6$ alky, or $R_1$/$R_2$ or $R_3$/$R_4$ form together with the carbon atoms to which they are attached, an aromatic $C_5$-$C_6$ ring; wherein said alkyl or aromatic ring being optionally substituted, preferably not substituted;
- each $L_1$ represents independently a single bond;
- each EnA represents independently an energy acceptor, preferably selected from polycyclic aromatic hydrocarbons comprising at least 3, preferably from 3 to 6, more preferably from 3 to 5, aromatic rings fused together, at least one of the aromatic rings being optionally interrupted by one or more heteroatoms selected among N, S or O and/or optionally substituted by one or more groups selected among =S, =O, a phenyl or a linear or branched, saturated or unsaturated, $C_1$-$C_6$ alkyl chain; and
- $X^-$ represents an inorganic or organic counterion, preferably an inorganic or organic anionic counterion, ensuring the electrical neutrality of the compound.

According to this embodiment, preferably, when EnA represents a pyrene, at least one of the aromatic rings is interrupted and/or substituted; preferably at least one of the aromatic rings is interrupted by one or more heteroatoms selected among N, S or O and/or substituted by one or more groups selected among =S, =O, a phenyl or a linear or branched, saturated or unsaturated, $C_1$-$C_6$ alkyl chain. More preferably, EnA is not a pyrene.

According to a preferred embodiment, the compound of the present invention is chosen from the compounds of formula (IV), wherein

- $R_1$, $R_2$, $R_3$ and $R_4$ are identical and represent H or a linear or branched, saturated or unsaturated, $C_1$-$C_6$ alkyl, preferably H;
- each $L_1$ represents independently a single bond;
- each EnA represents independently an energy acceptor, preferably selected from polycyclic aromatic hydrocarbons comprising at least 3, preferably from 3 to 6, more preferably from 3 to 5, aromatic rings fused together, at least one of the aromatic rings being optionally interrupted by one or more heteroatoms selected among N, S or O and/or optionally substituted by one or more groups selected among =S, =O, a phenyl or a linear or branched, saturated or unsaturated, $C_1$-$C_6$ alkyl chain; and
- $X^-$ represents an inorganic or organic counterion, preferably an inorganic or organic anionic counterion, ensuring the electrical neutrality of the compound.

According to this embodiment, preferably, when EnA represents a pyrene, at least one of the aromatic rings is interrupted and/or substituted; preferably at least one of the aromatic rings is interrupted by one or more heteroatoms selected among N, S or O and/or substituted by one or more groups selected among =S, =O, a phenyl or a linear or branched, saturated or unsaturated, $C_1$-$C_6$ alkyl chain. More preferably, EnA is not a pyrene.

Advantageously, the compounds of the present invention are chosen from

| | |
|---|---|
| 001 | 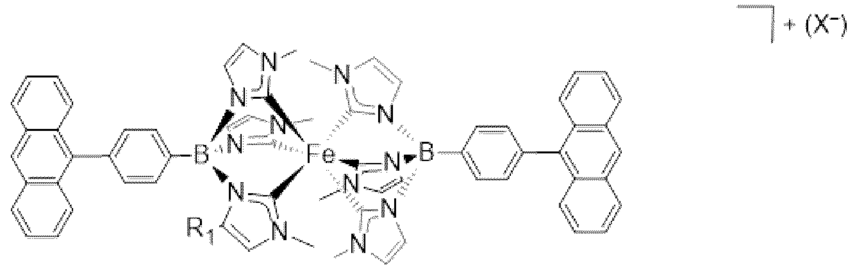 |
| 002 | 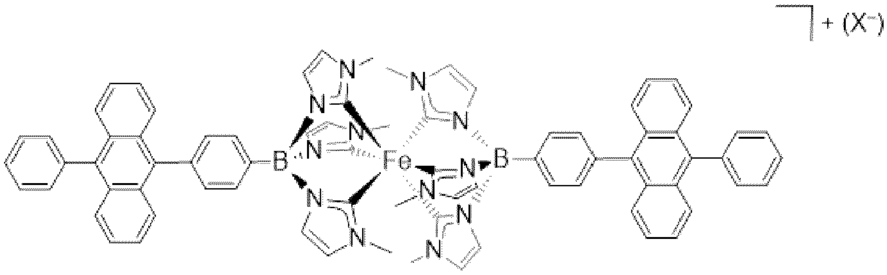 |
| 003 | 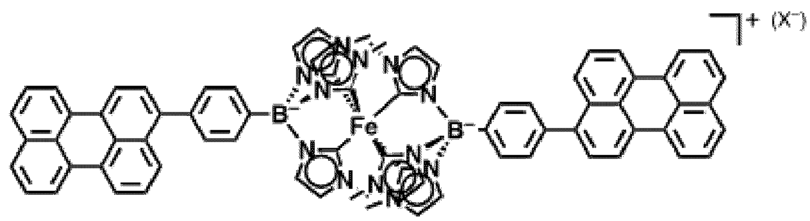 |
| 004 | 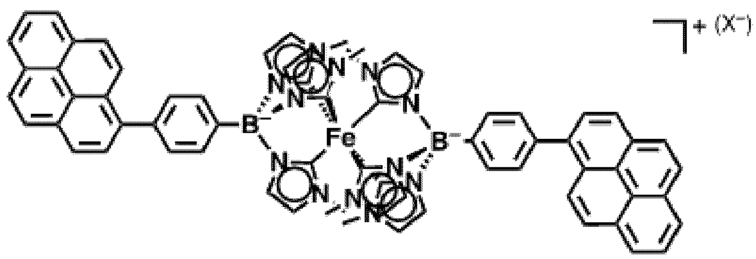 |

$X^-$ representing an inorganic or organic anionic counterion, ensuring the electrical neutrality of the compound.

Advantageously, the compounds of the present invention are chosen from compounds 001, 002 and 003 as defined hereabove.

Advantageously, $X^-$ is chosen from i) halides such as chloride, bromide or iodide; ii) nitrates such as $NO_3^-$; iii) sulfonates including $C_1$-$C_6$ alkylsulfonates: Alk-$S(O)_2O^-$ such as methylsulfonate or mesylate and ethylsulfonate; iv) arylsulfonates: Ar-$S(O)_2O^-$ such as benzenesulfonate and toluenesulfonate or tosylate ($TsO^-$); v) citrate; vi) succinate; vii) tartrate; viii) lactate; ix) alkyl sulfates: Alk-O-$S(O)O^-$ such as methyl sulfate and ethyl sulfate; x) aryl sulfates: Ar-O-$S(O)O^-$ such as benzene sulfate and toluene sulfate; xi) alkoxy sulfates: Alk-O-$S(O)_2O^-$ such as methoxy sulfate and ethoxy sulfate; xii) aryloxy sulfates: Ar-O-$S(O)_2O^-$, xiii) phosphates; xiv) acetate; xv) triflate ($TfO^-$); xvi) borates such as $BF_4^-$, $BPh_4^-$ or $[BAr^F{}_4]^-$, xvii) disulfate; and xviii) perchlorate ($ClO_4^-$). Preferably, $X^-$ is chosen from $Cl^-$, $Br^-$, $I^-$, $PF_6^-$, $BF_4^-$, $ClO_4^-$, $NO_3^-$, $TsO^-$, $BPh_4^-$, $[BAr^F{}_4]^-$ or $TfO^-$.

Advantageously, the compound of the invention, i.e. compound of formula (I), (II), (III) or (IV) as defined hereabove, is a photosensitizer. A "photosensitizer", also referring to "photocatalyst", corresponds to a compound that can sensitize a reaction using light.

The compound of the invention is preferably able to convert light energy into chemical energy by absorbing photons. Preferably, the compound of the invention, i.e. compound of formula (I), (II), (III) or (IV) as defined hereabove, absorbs from 200 to 750 nm, and more preferably from 250 to 600 nm.

**Process of manufacturing**

The compound of the present invention can be synthesized by methods known in the art. Especially, the

compound of the present invention can be synthesized by the methods detailed in the experimental part below.

## Composition

The present invention further relates to a composition comprising:

- a compound of the present invention, i.e. a compound of formula (I), (II), (III) or (IV) as defined hereabove, and
- a solvent, preferably being either (i) selected from the list consisting of water, acetonitrile, dichloromethane, dimethylformamide, ethyl acetate, organic solvents and mixtures thereof, or (ii) an aqueous solution comprising at least one polar aprotic or protic solvent different from the solvents (i).

All the definitions and characteristics described in the above section (i.e. Iron-based photosensitizers of formulae (I)-(IV)) apply *mutatis mutandis* in the present section.

Organic solvents that can used according to the present invention are preferably chosen from linear or branched $C_1$-$C_4$ alkanols, such as methanol or ethanol; polyols and polyol ethers; glycerol; aromatic alcohols or ethers, such as benzyl alcohol or phenoxyethanol. More preferably, the organic solvents are chosen from linear or branched $C_1$-$C_4$ alkanols, such as methanol or ethanol.

According to the present invention, an **"aqueous solution"** refers to a solution comprising at least 60% by weight, preferably 70% by weight, more preferably 80% by weight, better still 90%, and even 95% by weight of water, relative to the total weight of the aqueous solution.

Advantageously, the total content of polar aprotic or protic solvent(s), present in the aqueous solution when present, is lower than or equal to 10% by weight, more preferably ranges from 0.5 to 10% by weight, and more preferably from 1 to 5% by weight, relative to the total weight of the aqueous solution.

Preferably, the polar aprotic solvent, different from the solvents (i), that can be used in the aqueous solution of the present invention is chosen from acetone, dimethylpropyleneurea, dimethyl sulfoxide, hexamethylphosphoramide, pyridine, sulfolane, tetrahydrofuran, and mixtures thereof.

Preferably, the protic solvent, different from the solvent (ii) that can be used in the aqueous solution of the present invention is chosen from acetic acid, formic acid or ammonia.

Advantageously, the solvent is selected from the list consisting of water, acetonitrile, dichloromethane, dimethylformamide, ethyl acetate, organic solvents and mixtures thereof; more preferably from water, acetonitrile, dichloromethane and mixtures thereof. These solvents are commonly used and the skilled artisan will know how to combine them to obtain miscible mixtures.

## Uses of the compound of the present invention

The present invention further relates to the use of a compound of the invention, i.e. a compound of formula (I), (II), (III) or (IV) as defined hereabove, as a photosensitizer or as photocatalyst.

More particularly, the compound of the present invention can be used as photosensitizer for solar fuel formation. Thus, the present invention further relates to the use of the compound of the invention, i.e. a compound of formula (I), (II), (III) or (IV) as defined hereabove, for solar fuel formation.

According to the present invention a **"solar fuel"** refers to a synthetic fuel produced using solar energy, through photochemical reactions in presence of a photosensitizer. Example of solar fuels may include $H_2$, $CO_2$ reduction products, compound issued from water oxidation or halide oxidation.

The present invention further relates to the use of the compound of the invention, i.e. a compound of formula (I), (II), (III) or (IV) as defined hereabove, or of the composition of the invention as defined above, in photoredox catalysis or energy conversion.

The present invention thus relates to the use of the compound of the invention, i.e. a compound of formula (I), (II), (III) or (IV) as defined hereabove, or of the composition of the invention as defined above, in solar cell, in solar panels, in lighting systems, in hydrogen production or in carbon dioxide conversion.

The present invention relates to a compound of the present invention, i.e. a compound of formula (I), (II), (III) or (IV) as defined hereabove, or the composition of the present invention as defined above for use in photodynamic or photochemotherapy therapy. According to another embodiment, the present invention also relates to the use of a compound of the present invention, i.e. a compound of formula (I), (II), (III) or (IV) as defined hereabove, or of the composition of the present invention in photodynamic or photochemotherapy therapy.

## BRIEF DESCRIPTION OF THE DRAWING

**Figure 1** represents the excited-state lifetime of a) $[Fe(L^{Ph})_2]^+$ and b) compound (001) under air (light colors) and argon (dark colors)

**Figure 2** is the synthesis scheme of $^1O_2$-mediated oxidation of 1,5-dihydroxynaphthalene (DHN) to the corresponding 5-hydroxy-1,4-naphthalenedione (Juglone). DTET = doublet-to-triplet energy transfer, TTET = triplet-to-triplet energy transfer.

**Figure 3** represents the UV-vis traces of juglone after different irradiation times for a) $[Fe(L^{Ph})_2]^+$ and b) $[Fe(L^{PhAn})_2]^+$ (compound 001).

**Figure 4** represents the excited-state quenching of a) $[Fe(L^{Ph})_2]^+$ and of b) compound (001) by methylviologen. The upper part corresponds to the nanosecond transient absorption spectroscopy of a) $[Fe(L^{Ph})_2]^+$ and of b) compound (001), while the lower part corresponds to the nanosecond transient absorption spectroscopies of a) $[Fe(L^{Ph})_2]^+$ and of b) compound (001) with methylviologen. The inset shows the corresponding cage-escape plots. All spectra were recorded under argon in acetonitrile at room temperature.

## EXAMPLES

The present invention is further illustrated by the following examples.

### Materials and methods

Reagents and chemicals were purchased from commercial suppliers and used as received. $[Pd(PPh_3)_4]$ was synthesized following a literature and stored under argon in the fridge.

**Nuclear Magnetic Resonance.** $^1$H-NMR spectroscopy was performed on a JEOL JNM-ECZL R (400 MHz and 600 MHz) at 293 K. The chemical shifts (in ppm) were measured versus the residual peak of the solvent as an internal standard.

**UV-Visible Absorption.** UV-vis absorption spectra were recorded on an Agilent Cary 60 spectrophotometer in a quartz cuvette with a 1 cm path length. Molar absorption coefficients were determined in at least two independent measurements with a less than 3% standard deviation.

### Example 1: Synthesis and characterization of iron-based photosensitizers of formula (I)

***Example 1-a: Synthesis of $[Fe(L^{PhBr})_2](PF_6)$***

The brominated ligand $L^{PhBr}(PF_6)_2$ was synthesized following procedure published in the literature. The iron-complex $[Fe(L^{PhBr})_2](PF_6)$ was synthesized as shown in scheme 1.

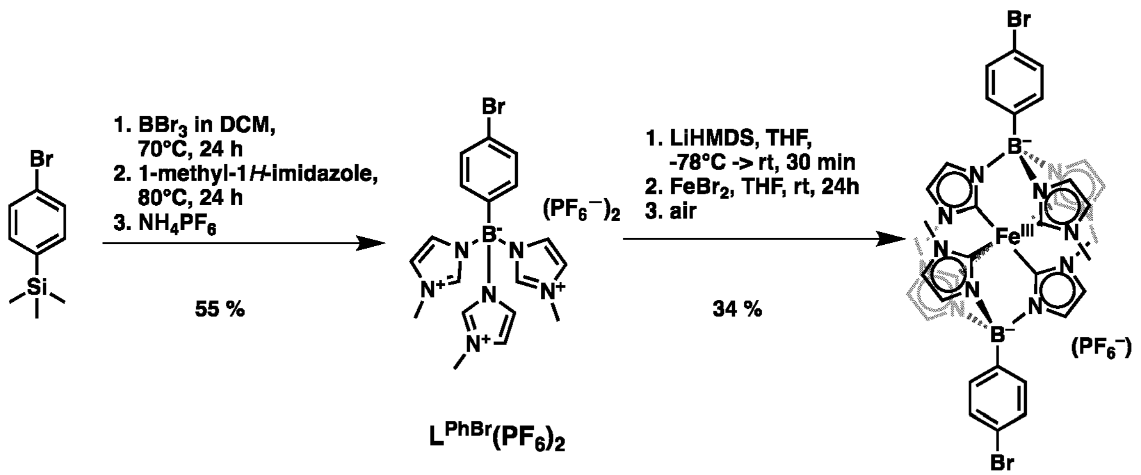


$L^{PhBr}(PF_6)_2$

$[Fe(L^{PhBr})_2](PF_6)$

**Scheme 1: Synthesis of the brominated ligand $L^{PhBr}(PF_6)_2$**

$L^{PhBr}(PF_6)_2$ (1.51 g, 2.15 mmol, 2.2 eq.) was added to a 100 mL Schlenk flask and dried under vacuum at 80°C for 20 h. Dry THF (45 mL) was added under Argon and the reaction mixture was cooled to -78°C. A solution of LiHMDS (1.21 g, 7.25 mmol, 7.3 eq.) in THF (15 mL) was added dropwise and the solution was stirred for 15 minutes and then allowed to warm to room temperature over 30 minutes. A solution of $FeBr_2$ (215 mg, 1.00 mmol, 1.0 eq.) in THF (40 mL) was sonicated for 20 minutes under Argon and then added slowly to the clear solution of the deprotonated ligand. The reaction mixture was stirred for 20 hours in the dark. Then the solution was exposed to air, inducing a fast color change from black to bright red. The solvent was removed and the residue dissolved in dichloromethane, filtered through a filter frit (POR3) and the solvent was removed to isolate the crude product. The pure product was isolated after flash column chromatography (neutral $Al_2O_3$, DCM → DCM/MeCN 511) as a dark red solid (696 mg,682 μmol, 34 %).

1H-NMR (400 MHz, CD3CN): 14.83 (d, *J* = 5.2 Hz, 4H), 10.61 (d, *J* = 5.3 Hz, 4H), 4.90 (s, 18H), 1.32 (s, 6H), -12.65 (s, 6H) ppm.

***Example 1-b: Synthesis and characterization of compound (001)***

Compound 001, also referred as $[Fe(L^{PhAn})_2](PF_6)$ was synthesized as shown in Scheme 2.

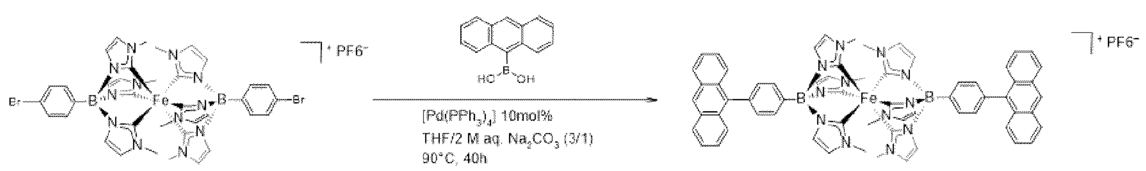


$[Fe(L^{PhBr})_2](PF_6)$ $[Fe(L^{PhAn})_2](PF_6)$

## Scheme 2: Synthesis of $[Fe(L^{PhAn})_2](PF_6)$ (compound 001)

A 25 mL ACE pressure tube was charged with 9-anthraceneboronic acid (65.0 mg, 294 μmol, 3.0 eq.) and $[Fe(L^{PhBr})_2](PF_6)$ (100 mg, 98.0 μmol, 1.0 eq.). THF (2.25 mL) was added under Argon and the suspension was purged with Argon for 5 minutes. Then $[Pd(PPh_3)_4]$ (11.3 mg, 9.8 μmol, 0.1 eq.) and pre-purged aqueous sodium carbonate solution (2 M, 0.75 mL) were added. The reaction mixture was purged with Argon for another 10 minutes, sealed under Argon and heated to 90 °C for 40 h. The reaction mixture was cooled to room temperature, diluted with water (20 mL), extracted with dichloromethane (3x 50 mL) and the organic phase was dried over anhydrous sodium sulfate. After filtration, the solvent was removed under reduced pressure and the crude red product was filtrated through a short $Al_2O_3$ column (MeCN → MeCN/water 20/1) and then purified by column chromatography ($SiO_2$, MeCN/$H_2O$/sat. aq. $KNO_3$ 20/1/1) and reprecipitated from an aqueous solution with KPF6 to obtain the desired product (62.3 mg, 51.3 μmol, 52%).

$^1H$ NMR (600 MHz, DMSO-$d_6$) δ 15.13 (s, 4H), 10.54 (s, 4H), 9.95 (d, J = 8.9 Hz, 4H), 9.40 (s, 2H), 8.80 (d, J = 8.9 Hz, 4H), 8.41 (dd, J = 9.0, 4.7 Hz, 4H), 8.15 (dd, J = 8.7, 5.3 Hz, 4H), 5.17 (s, 18H), 1.29 (s, 6H), -12.31 (s, 6H).

High resolution ESI-MS m/z calculated for $[C_{64}H_{56}B_2FeN_{12}]^+$ = 1070.42809; found 1070.43006.

*Example 1-c: Synthesis and characterization* ***of*** *compound (002)*

Compound 002 was synthesized as shown in Scheme 3.

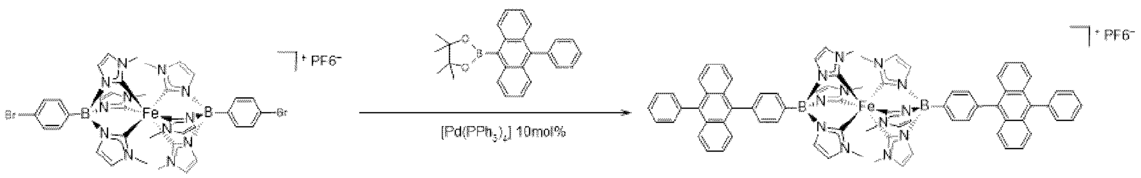


$[Fe(L^{PhBr})_2](PF_6)$ 002

## Scheme 3: Synthesis of compound 002

The brominated complex $[Fe(L^{PhBr})_2]^+$ (100 mg, 98.0 μmol, 1.0 eq.) was coupled with 9-phenylanthracene pinacolboronic ester (110 mg, 294 μmol, 3.0 eq.) in presence of $[Pd(PPh_3)_4]$ (11.3 mg, 9.80 μmol, 10 mol%) in a mixture of THF (2.25 mL) and aqueous sodium carbonate solution (2 M, 0.75 mL) at 90 °C for 45 hours to generate compound 002 (51.5 mg, 37.7 μmol, 38%) after purification by size exclusion (DCM) and flash column chromatography ($SiO_2$,

Toluene/DCM/MeCN 3:3:1).

$^1$H NMR (600 MHz, MeCN-$d_3$) δ 15.05 (s, 4H), 10.51 (s, 4H), 10.01 (d, J = 8.7 Hz, 4H), 8.34 (dd, J = 8.7, 5.3 Hz, 4H), 8.25 (d, J = 9.1 Hz, 4H), 8.05 - 7.95 (m, 12H), 7.88 (t, J = 7.4 Hz, 2H), 5.13 (s, 6H), -12.59 (s, 6H) ppm.

***Example 1-d: Synthesis and characterization of compound (003)***

Compound 003 was synthesized as shown in Scheme 4.

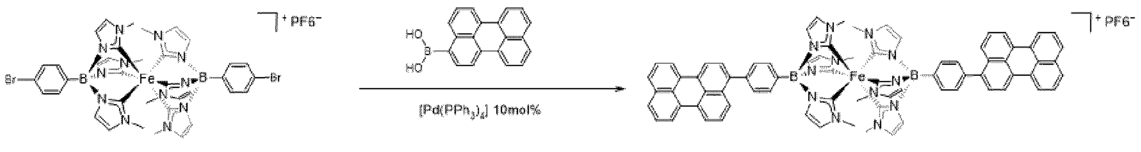


$[Fe(L^{PhBr})_2](PF_6)$

003

**Scheme 4:** Synthesis of compound 003

The brominated complex $[Fe(L^{PhBr})_2]^+$ (100 mg, 98.0 µmol, 1.0 eq.) was coupled with perylene-3-boronic acid (87.6 mg, 294 µmol, 3.0 eq.) in presence of $[Pd(PPh_3)_4]$ (11.3 mg, 9.80 µmol, 10 mol%) in a mixture of THF (2.25 mL) and aqueous sodium carbonate solution (2 M, 0.75 mL) at 90 °C for 45 hours to generate compound 003 (10.2 mg, 7.48 µmol, 8%) after purification by size exclusion chromatography (MeCN) and two subsequent column chromatography ($SiO_2$, Toluene/DCM/MeCN 3:3:1).

$^1$H NMR (400 MHz, DMSO-$d_6$) δ 15.04 (s, 4H), 10.64 (d, J = 5.0 Hz, 4H), 9.96 (d, J = 8.4 Hz, 2H), 9.32 (d, J = 8.2 Hz, 2H), 9.25 (d, J = 7.0 Hz, 2H), 9.00 (d, J = 7.8 Hz, 2H), 8.95 (d, J = 7.7 Hz, 2H), 8.81 (d, J = 7.7 Hz, 2H), 8.44 (dd, J = 8.4, 6.9 Hz, 2H), 8.08 (dd, J = 8.3, 6.5 Hz, 4H), 7.89 (dd, J = 8.1, 6.9 Hz, 2H), 7.83 (dd, J = 8.2, 7.0 Hz, 2H), 4.60 (s, 18H), 1.20 (s, 6H), -12.41 (s, 6H) ppm.

**Example 2: Evaluation of the excited-state lifetime**

The excited-state lifetime of $[Fe(L^{PhAn})_2](PF_6)$ (corresponding to the compound 001) synthetized hereabove according to example 1-a was then compared to the excited-state lifetime of the complex $[Fe(L^{Ph})_2](PF_6)$.

**Materials and Methods**

***Synthesis of $[Fe(L^{Ph})_2](PF_6)$***

$[Fe(L^{Ph})_2](PF_6)$ was synthesized as shown in Scheme 6.

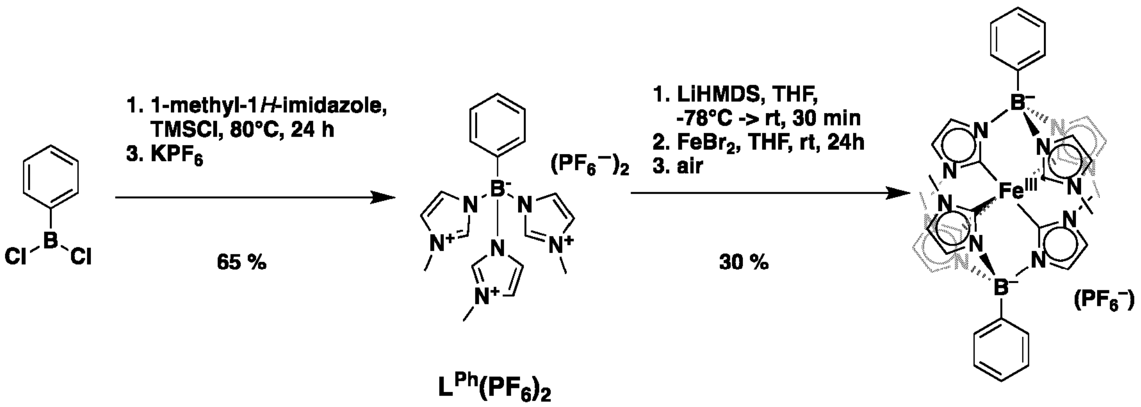


$[Fe(L^{Ph})_2](PF_6)$

**Scheme 6:** Synthesis of $[Fe(L^{Ph})_2](PF_6)$

The unmodified ligand $L^{Ph}(PF_6)_2$ was synthesized following procedure published in the literature.

$L^{Ph}(PF_6)_2$ (1.24 g, 1.95 mmol, 2.1 eq.) was added to a 100 mL Schlenk flask and dried under vacuum at 80°C for 20 h. Dry THF (40 mL) was added under Argon and the reaction mixture was cooled to -78°C. A solution of LiHMDS (1.09 g, 6.50 mmol, 7.0 eq.) in THF (13 mL) was added slowly and the solution was stirred for 15 minutes and then allowed to warm to room temperature over 30 minutes. A solution of $FeBr_2$ (200 mg, 930 μmol, 1.0 eq.) in THF (35 mL) was sonicated for 20 minutes under Argon and then added slowly to the clear solution of the deprotonated ligand. The reaction mixture was stirred for 20 hours in the dark. Then the solution was exposed to air, inducing a fast color change from black to bright red. The solvent was removed and the residue dissolved in dichloromethane, filtered through a filter frit (POR 3) and the solvent was removed to isolate the crude product. The pure product was isolated after flash column chromatography (neutral Al2O3, DCM → DCM/MeCN 511) as a dark red solid (248 mg, 927 μmol, 30 %).

$^1$H-NMR (400 MHz, $CD_3CN$): 14.94 (d, *J* = 5.2 Hz, 4H), 10.48 (t, *J* = 5.5 Hz, 4H), 9.81 (t, *J*= 7.3 Hz, 2H), 4.87 (s, 18H), 1.58 (s, 6H), -12.72 (s, 6H) ppm.

***Evaluation of the excitation-state lifetime***

Time-resolved and steady-state photoluminescence spectra were recorded on an Edinburgh Instruments FS5 Spectrofluorometer equipped with a time-correlated single photon counting module. The steady-state photoluminescence spectra were recorded using a 150 W Xenon arc lamp as the excitation source. The photoluminescence was detected at a right angle to the excitation beam using a single photon counting PMT-900 in a temperature stabilized housing. The spectra were integrated at 0.2 s and three spectra were averaged. Steady-state photoluminescence spectra were corrected for the instrument's spectral response. All room-temperature spectra were obtained from Argon-sparged solutions unless otherwise mentioned.

Time-resolved photoluminescence data were collected on the FS5 using the time-correlated single photon counting technique (TCSPC). Excitation was achieved with a 510 ± 5 nm diode laser (Edinburgh Instruments EPL-510, 90 ps pulse width at 10 MHz). Photons reaching the detector were accumulated to reach a count of 10000.

Nanosecond transient absorption (ns-TA) measurements were recorded on a LP980-K spectrometer from Edinburgh Instruments equipped with an iCCD detector from Andor (DH320T). The excitation source was a tunable Nd:YAG Laser NT342 Series from EKSPLA. The third harmonic (355 nm) at 150 mJ was directed into an optical parametric oscillator (OPO) to enable wavelength tuning starting from 410 nm. The laser power was then attenuated to reach appreciable signal/noise and the integrity of the samples was verified by UV-vis measurements. The LP980-K is equipped with a symmetrical Czemy-Tumer monochromator. For single wavelength absorption changes, a 1800 g $mm^{-1}$ grating, blazed at 500 nm is used, which affords wavelength coverage from 200 to 900 nm. For spectral mode (iCCD), a 150 g $mm^{-1}$ grating, blazed at 500 nm is used, offering a wavelength coverage of 540 nm over the full wavelength range extending from 250 to 900 nm. Single wavelength absorption changes were monitored using a PMT LP detector (Hamamatsu R928) which covers the spectral range from 185 to 870 nm. The probe was a 150 W ozone-free xenon short arc lamp (OSRAM XBO 150W/CR OFR) that was pulsed at the same frequency of the laser. All measurements were performed in argon-purged acetonitrile at room temperature. An average of 15 to 50 scans per measurement was used. All solutions were purged with argon for 10-15 minutes unless otherwise stated. The excited-state lifetime of compound 001 was recorded at 430 nm.

**Results**

The results are shown in Figure 1. The excited-state lifetime of the compound 001 (Fig. 1b) is significantly higher than the excited-state lifetime of the complex $[Fe(L^{Ph})_2](PF_6)$ (Fg. 1a). Indeed, under aerated conditions (i.e. under air), the excited-state lifetime of the compound 001, in acetonitrile, is 165 ns, whereas the lifetime of the complex $[Fe(L^{Ph})_2](PF_6)$, in acetonitrile, is only of 2.05 ns (Figure 1.a). This increase is even higher under argon conditions since the excited-state lifetime of the compound 001, in acetonitrile, reaches 11.5 μs (more than 5000-fold increase).

Furthermore, the excited-state lifetime of compounds 002 and 003 have been measured according to the same protocol as defined hereabove. The results thus obtained show that the excited-state lifetime of both compounds 002 and 003 in acetonitrile, under argon conditions, is of about 10 μs.

These results show that the presence of the energy acceptor moiety drastically improves the excited-state lifetime of iron-based complexes, making them good candidates for photocatalysis.

**Example 3: Singlet oxygen formation and generation of juglone**

The efficiency of the complex $[Fe(L^{Ph})_2](PF_6)$ and of the compound 001 (also referred as $[Fe(L^{PhAn})_2](PF_6)$), synthetized hereabove according to example 1-a, to produce $^1O_2$ was evaluated using the $^1O_2$-mediated oxidation of 1,5-dihydroxynaphthalene (DHN) to the corresponding 5-hydroxy-1,4-naphthalenedione (Juglone) using the synthesis scheme shown on figure 2.

## Materials and Methods

Generation of $^1O_2$ under different conditions was indirectly detected through the trapping with 1.5-naphtalenediol. The formation of 5-hydroxy-1,4-naphthoquinone (Juglone, molar absorption coefficient of 3810 $M^{-1}cm^{-1}$ at 427 nm) was monitored by UV-vis spectroscopy on the Agilent Cary 60 spectrophotometer described above utilizing quartz cuvettes with a pathlength of 2 mm.

In a scintillation vial equipped with a magnetic stir bar, 1,5-dihydroxynaphthalene (DHN, 20.0 mg, 25 mM, 1.0 eq.) and the photosensitizer (250 μM, 1 mol%) were added, dissolved in acetonitrile (5 mL) and sonicated for 3 minutes. The flask was mounted in the irradiation setup and stirred during the whole experiment open to air unless otherwise stated. Before the measurements and after specific irradiation times, the irradiation was interrupted and UV-vis absorption spectra of the solution were recorded. For the measurement of the absorption spectra, a ~500 μL aliquot of the stirred solution was measured in a 2 mm quartz cuvette. After the measurements the solutions were transferred back to the glass vial and the irradiation was continued. As light source, a green LED (Thorlabs LIU525B M4, 111 mW and ca. 1.9mW $cm^2$ at a distance of 100 mm according to the supplier) equipped with a long-pass filter (Newport 20CGA-475 HA498) was used. Product formation of Juglone was evaluated based on the difference in absorbance (ΔAbs) at 427 nm ($\varepsilon_{427nm}$ = 3810 $M^{-1}$ cm-1).

## Results

The results are shown in Figure 3 and table 1

| Conditions | $k_{obs}$ / $10^{-3}h^{-1}$ | relative rate vs $k_{obs,[Fe(LPh)2]}$ |
|---|---|---|
| $[Fe(L^{Ph})_2]^+$ | 1.2 | 1 |
| $[Fe(L^{PhAn})_2]^+$ | 12 | 10 |
| $[Fe(L^{PhAn})_2]^+$ no irraditiation | <0.001 | <0.001 |
| No photosensitizer | 0.001 | 0.001 |

Due to its short excited-state lifetime, $[Fe(L^{Ph})_2]^+$ was unable to produce enough $^1O_2$ to convert DHN to Juglone. In comparison, compound 001 (also referred as $[Fe(L^{PhAn})_2]^+$) was able to efficiently generate Juglone. The long excited-state lifetime of compound 001 enhanced the production of $^1O_2$, which then triggered the conversion of DHN to Juglone, as shown in figure 2.

These results show that the compound according to the present invention can generate enough singlet oxygen and thus be used as photosensitizer in photoredox and photocatalytic processes.

## Example 4: Cage escape yields ($\Phi_{CE}$)

The cage escape yield (**$\Phi_{CE}$**) corresponds to the efficiency with which radicals escape the solvent cage following bimolecular electron transfer. $\Phi_{CE}$ of the compound 001 (also referred as $[Fe(L^{PhAn})_2](PF_6)$), synthetized hereabove according to example 1-a was then compared to $\Phi_{CE}$ of the complex $[Fe(L^{Ph})_2](PF_6)$.

## Materials and Methods

The cage escape yields (**$\Phi_{CE}$**) were evaluated using the model reaction of the oxidative quenching by methylviologen ($MV^{2+}$).

An argon-purged solution of $[Ru(bpy)_3]^{2+}$ in acetonitrile with the same absorbance (Abs ~0.2) at the excitation wavelength as the respective solution of the investigated system (e.g. $[Fe(L^{Ph})_2]^+$ and $MV^{2+}$ in acetonitrile) serves as actinometer to determine the unknown concentration of generated photoproducts. The absorbance of the reference system ($Abs_{ref}$) and of the investigated system ($Abs_{PS}$) at the excitation wavelength ($\lambda_{exc}$) was determined by UV-vis spectroscopy. The reference sample was then irradiated using pulsed light excitation while monitoring the bleach at 455 nm ($\Delta A_{ESref}$) on the nanosecond UV-vis TA setup. A Δε value of -10100 $M^{-1}cm^{-1}$ was used for the actinometer at 455 nm to calculated the concentration under the given experimental conditions. For samples with different concentrations of quencher, fresh solutions from suitable stock solutions were prepared. These quencher solutions were prepared in stock solution of the photosensitizers to ensure constant absorption. The percentage of quenched excited states (η in Equation 1) at a given concentration of quencher was determined by time-resolved photoluminescence or by transient absorption measurements. The signal of the photoproducts (abbreviated as $\Delta A_{PS+}$) were recorded at a wavelength with known molar

absorption coefficients ($\Delta\varepsilon_{PS+}$). With these experimentally determined values and using equation 1 and 2, the relative yield of photoproduct ($\Phi$, also referred to as apparent cage escape yield) was plotted against the percentage of quenched excited state ($\eta$) and final cage escape yields ($\Phi$ CE) values were obtained from the slope of the linear fit. For compound 001, the cage escape yield was determined based on the concentration of $^{3*}[Fe(L^{PhAn})_2]^+$ in the absence of quencher as actinometer. For the complex $[Fe(L^{Ph})_2](PF_6)$, the quenching efficiency $\eta$ was determined by time-resolved single photon counting on the FS5 Spectrofluorometer described in example 2.

$$\Phi_{CE} = \frac{\Phi}{\eta}$$

Equation 1

$$\Phi = \left( \frac{\frac{\Delta A_{PS^+}}{\Delta \varepsilon_{PS^+}}}{\frac{\Delta A_{ES_{ref}}}{\Delta \varepsilon_{ES_{ref}}}} \right) \left( \frac{1 - 10^{-Abs_{ref}(\lambda_{exc})}}{1 - 10^{-Abs_{PS}(\lambda_{exc})}} \right)$$

Equation 2

**Results**

The results are shown in Figure 4. In acetonitrile, $^{2*}[Fe(E^{ph})_2]^+$ was dynamically quenched by $MV^{2+}$ with a $k_q$ of $2.3 \cdot 10^9$ $M^{-1}s^{-1}$. Despite a large quenching rate constant, $\Phi_{CE}$ in acetonitrile only reached 4.5%. In comparison, when $[Fe(L^{PhAn})_2]^+$ (compound 001) was used, a $k_q$ of $1.4 \cdot 10^9$ $M^{-1}s^{-1}$ was determined with drastically increased $\Phi_{CE}$ to reach values of 42($\pm$1)%, i.e. a one order of magnitude increase compared to the case of $[Fe(L^{Ph})_2]^+$.

The compound of the invention presents thus a drastically increased ($\Phi_{CE}$, which, in combination with its long excited-state lifetime, allows its improved use as photosensitizer in photochemical and photophysical processes.

**Claims**

**1.** A compound of formula (I):

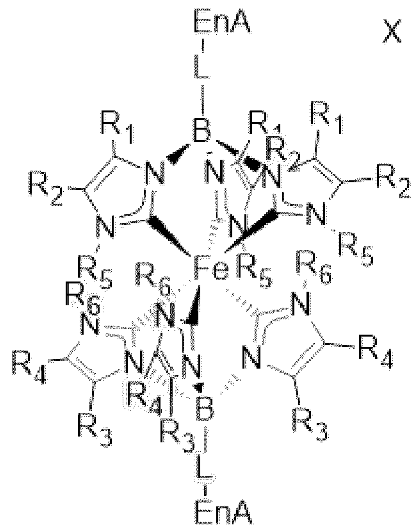

(I)

wherein,

- $R_1$, $R_2$, $R_3$ and $R_4$, identical or different, represent, independently from one another, H, a halogen, a linear or branched, saturated or unsaturated, $C_1$-$C_{12}$ alkyl, an aryl, an heteroaryl or $R_1/R_2$ or $R_3/R_4$ form together with the

carbon atoms to which they are attached, an aromatic $C_5$-$C_6$ ring; wherein said alkyl, aryl, heteroaryl or aromatic ring being optionally substituted;

- $R_5$ and $R_6$, identical or different, represent, independently from one another, H, a linear or branched, saturated or unsaturated, $C_1$-$C_{12}$ alkyl, a $C_3$-$C_7$ cycloalkyl, or an aryl; wherein said alkyl, cycloalkyl or aryl being optionally substituted;

- each L represents independently a single bond or a linker selected from alkyl, heteroalkyl, cycloalkyl, heterocycloalkyl, alkenyl, alkynyl, aryl, alkylaryl, arylalkyl, heteroaryl, heteroarylalkyl and alkylheteroaryl; wherein said alkyl, heteroalkyl, cycloalkyl, heterocycloalkyl alkenyl, alkynyl, aryl, alkylaryl, arylalkyl, heteroaryl, heteroarylalkyl or alkylheteroaryl being optionally substituted;

- each EnA represents independently an energy acceptor, preferably selected from polycyclic aromatic hydrocarbons comprising at least 3 aromatic rings fused together, at least one of the aromatic rings being optionally interrupted and/or optionally substituted; and

- X represents an inorganic or organic counterion, ensuring the electrical neutrality of the compound; with the proviso that when L represents a single bond or

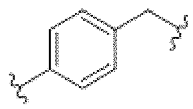

-;

EnA does not represent a pyrene.

**2.** The compound according to claim 1, wherein said compound is of formula (II):

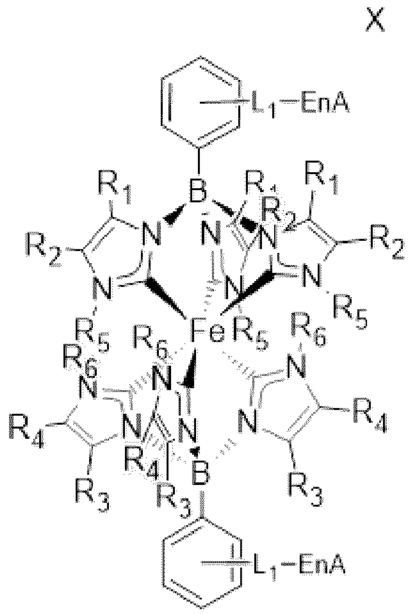

(II)

wherein, $R_1$, $R_2$, $R_3$, $R_4$, $R_5$, $R_6$, EnA and X are such as defined in claim 1; and

- each $L_1$ represents independently a single bond or a linker selected from alkyl, heteroalkyl, cycloalkyl, heterocycloalkyl, alkenyl, alkynyl, aryl, alkylaryl, arylalkyl, heteroaryl, heteroarylalkyl and alkylheteroaryl; wherein said alkyl, heteroalkyl, cycloalkyl, heterocycloalkyl alkenyl, alkynyl, aryl, alkylaryl, arylalkyl, heteroaryl, heteroarylalkyl or alkylheteroaryl being optionally substituted;

with the proviso that when $L_1$ represents a single bond in para position; EnA does not represent a pyrene.

**3.** The compound according to claim 1 or 2, wherein said compound is of formula (IV):

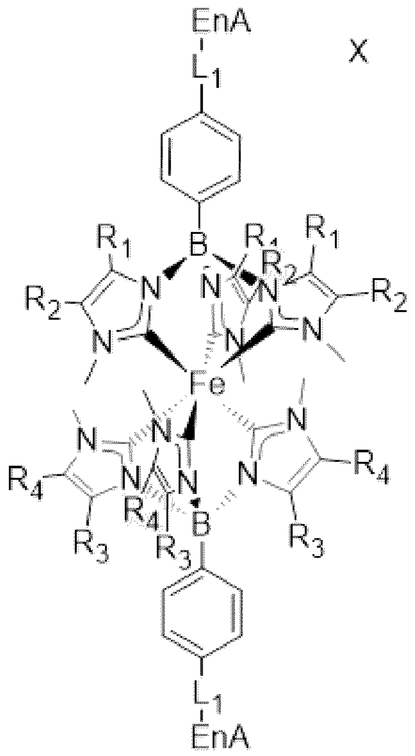

(IV)

wherein, $R_1$, $R_2$, $R_3$ and $R_4$, $L_1$, EnA and X are as such as defined in claim 2, with the proviso that when $L_1$ represents a single bond; EnA does not represent a pyrene.

4. The compound according to anyone of claims 1 to 3, wherein $R_1$, $R_2$, $R_3$ and $R_4$, identical or different represent, independently from one another, H, a halogen, a linear or branched, saturated or unsaturated, $C_1$-$C_{12}$ alkyl, an aryl, an heteroaryl; wherein said alkyl, aryl or heteroaryl being optionally substituted; preferably $R_1$, $R_2$, $R_3$ and $R_4$, identical or different represent independently from one another, H, a linear or branched, saturated or unsaturated, $C_1$-$C_6$ alkyl; wherein said alkyl being optionally substituted .

5. The compound according to anyone of claims of claims **1** to **4,** wherein $R_1$, $R_2$, $R_3$ and $R_4$ are identical.

6. The compound according to anyone of claims **1** to **5,** each $L_1$ represents independently a single bond or a linker selected from, optionally substituted, $C_2$-$C_6$ alkyl, $C_1$-$C_6$ heteroalkyl, $C_3$-$C_6$ cycloalkyl, $C_3$-$C_6$ heterocycloalkyl, aryl, ($C_1$-$C_6$)alkylaryl, aryl($C_1$-$C_6$)alkyl, heteroaryl, heteroaryl($C_1$-$C_6$)alkyl and alkylheteroaryl; preferably selected from aryl, ($C_1$-$C_6$)alkylaryl, aryl($C_1$-$C_6$)alkyl, wherein said aryl or alkyl being optionally substituted.

7. The compound according to anyone of claims **1** to **6,** wherein each $L_1$ represents a single bond.

8. The compound according to anyone of claims **1** to **7,** each EnA represents independently an energy acceptor selected from polycyclic aromatic hydrocarbons comprising from 3 to 70, preferably from 3 to 20, more preferably from 3 to 10 aromatic rings fused together, at least one of the aromatic rings being optionally interrupted and/or optionally substituted; preferably at least one of the aromatic rings being optionally interrupted by one or more heteroatoms selected among N, S or O and/or optionally substituted by one or more groups selected among =S, =O, a phenyl or a linear or branched, saturated or unsaturated, $C_1$-$C_6$ alkyl chain.

9. The compound according to anyone of claims **1** to **8,** wherein EnA are identical.

10. The compound according to anyone of claims **1** to **9,** wherein said compound is selected from:

| | |
|---|---|
| 001 | 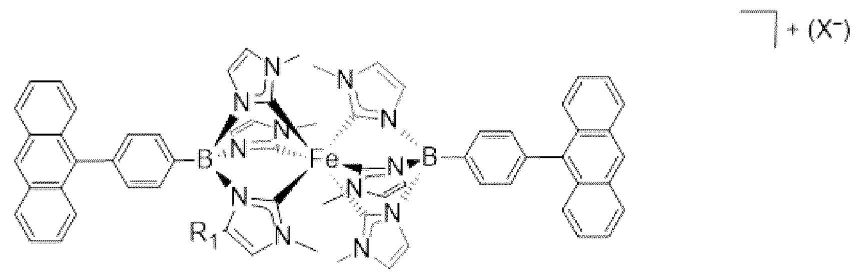 |
| 002 | 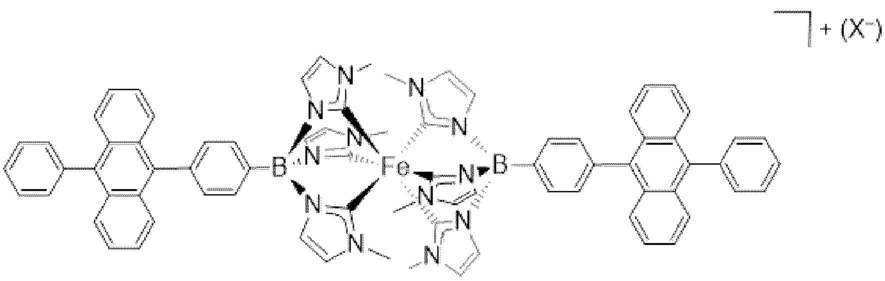 |
| 003 | 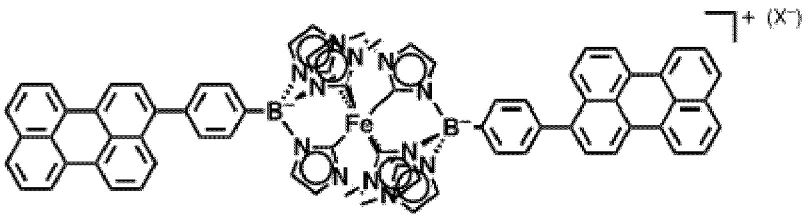 |
| 004 | 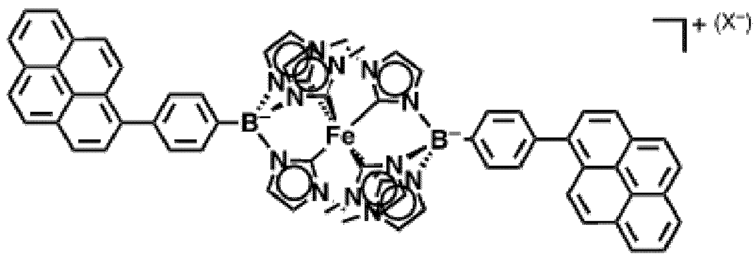 |

$X^-$ represents an inorganic or organic anionic counterion, ensuring the electrical neutrality of the compound.

**11.** The compound according to any of claims **1** to **10,** wherein said compound is a photosensitizer.

**12.** Use of a compound according to anyone of claims **1** to **10** as photosensitizer.

**13.** Use of a compound according to anyone of claims **1** to **11** in solar cell, in solar panels, in lighting systems, in hydrogen production or in carbon dioxide conversion.

**14.** Composition comprising a compound as defined in anyone of claims **1** to **11** and a solvent, preferably being either (i) selected from the list consisting of water, acetonitrile, dichloromethane, dimethylformamide, ethyl acetate, organic solvents and mixtures thereof, or (ii) an aqueous solution comprising at least one polar aprotic or protic solvent different from the solvents (i).

**15.** The compound according to any of claims **1 to 11** or the composition according to claim **14** for use in photodynamic or photochemotherapy therapy.

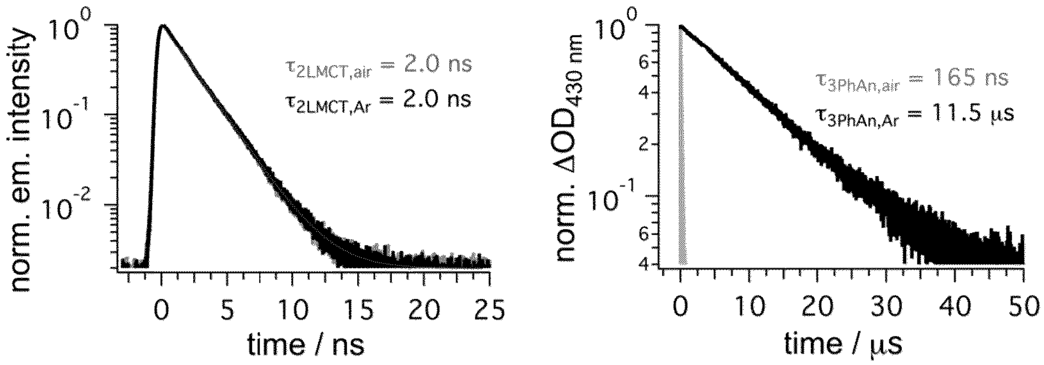

norm. em. intensity
$10^0$
$10^{-1}$
$10^{-2}$
$\tau_{2LMCT,air}$ = 2.0 ns
$\tau_{2LMCT,Ar}$ = 2.0 ns
-0 5 10 15 20 25
time / ns
norm. $\Delta OD_{430\ nm}$
$10^0$
$10^{-1}$
$\tau_{3PhAn,air}$ = 165 ns
$\tau_{3PhAn,Ar}$ = 11.5 μs
0 10 20 30 40 50
time / μs


**FIG. 1**

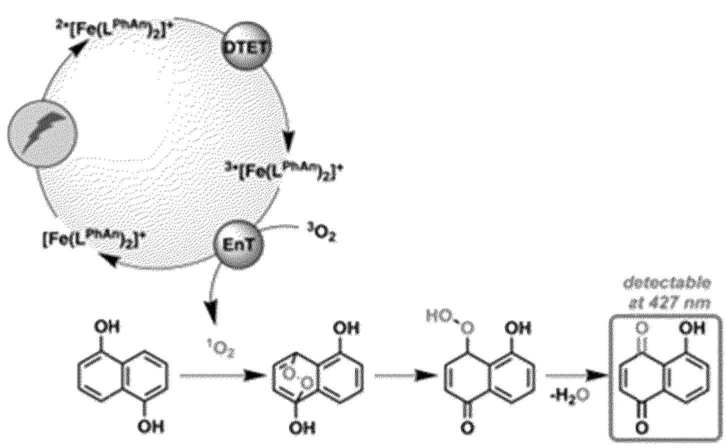

$^{2*}[Fe(L^{PhAn})_2]^+$
DTET
$^{3*}[Fe(L^{PhAn})_2]^+$
$[Fe(L^{PhAn})_2]^+$
EnT
$^3O_2$
$^1O_2$
$-H_2O$
detectable at 427 nm


**FIG.2**

2/2

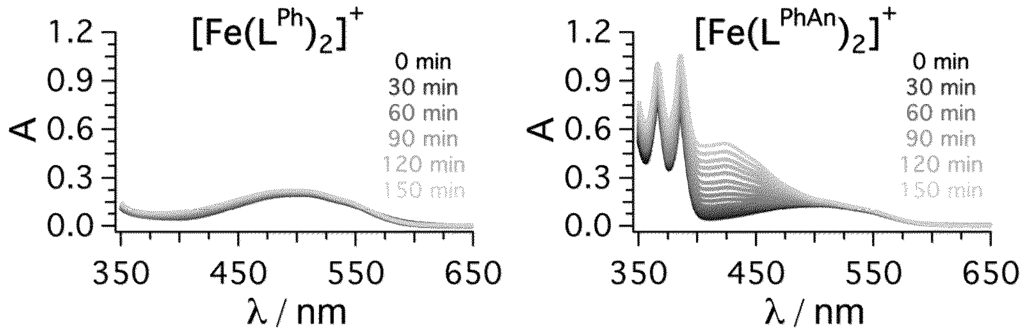

[Fe(L^Ph)2]+
[Fe(L^PhAn)2]+
1.2
0.9
0.6
0.3
0.0
A
0 min
30 min
60 min
90 min
120 min
150 min
350
450
550
650
λ / nm


**FIG.3**

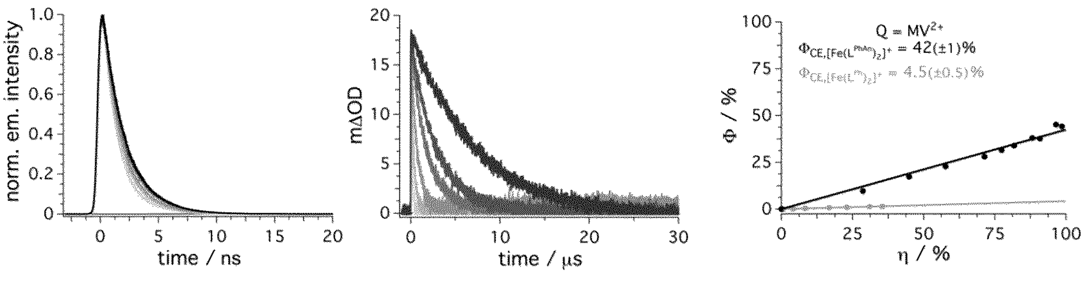

norm. em. intensity
time / ns
mΔOD
time / μs
Q = MV2+
= 42(±1)%
= 4.5(±0.5)%
Φ / %
η / %


**FIG. 4**

Europäisches Patentamt
European Patent Office
Office européen des brevets

# EUROPEAN SEARCH REPORT

Application Number
EP 24 22 1294

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | ROSEMANN NILS W. ET AL: "Tracing the Full Bimolecular Photocycle of Iron(III)-Carbene Light Harvesters in Electron-Donating Solvents", JOURNAL OF THE AMERICAN CHEMICAL SOCIETY, vol. 142, no. 19, 19 April 2020 (2020-04-19), pages 8565-8569, XP093280559, ISSN: 0002-7863, DOI: 10.1021/jacs.0c00755 Retrieved from the Internet: URL:http://pubs.acs.org/doi/pdf/10.1021/jacs.0c00755> * compound FeIII(phtmeimb)2+ PF6- page 8565 * ----- | 1-15 | INV. C07F15/02 C09K11/06 H10K85/60 |

TECHNICAL FIELDS SEARCHED (IPC)

C07F
H05B
C09K
H10K

The present search report has been drawn up for all claims

| Place of search | Date of completion of the search | Examiner |
|---|---|---|
| The Hague | 23 May 2025 | Bourghida, E |

1

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)